# EUROPEAN PATENT SPECIFICATION

(11) **EP 3 603 876 B1**
(45) Date of publication and mention of the grant of the patent: **03.11.2021**
(21) Application number: 18777815.4
(22) Date of filing: 07.03.2018
(51) Int. Cl.: B22F 1/00, H05K 3/34, B23K 35/30, B23K 35/02, B22F 7/00, B23K 35/40, B23K 35/26, B22F 1/02, B22F 3/11, H01L 21/48, H01L 23/14

(54) **MOLDED BODY FOR JOINING AND METHOD FOR MANUFACTURING SAME**
FORMKÖRPER ZUM VERBINDEN UND VERFAHREN ZUR HERSTELLUNG DAVON
CORPS MOULÉ DESTINÉ À UN ASSEMBLAGE ET SON PROCÉDÉ DE FABRICATION

(30) Priority: 31.03.2017 JP 2017071961
(43) Date of publication of application: 05.02.2020
(73) Proprietor: Mitsubishi Materials Corporation, Chiyoda-ku Tokyo 100-8117 (JP)
(72) Inventor: HIGAMI, Akihiro, Naka-shi Ibaraki 311-0102 (JP); MURAOKA, Hiroki, Naka-shi Ibaraki 311-0102 (JP); IWATA, Kotaro, Naka-shi Ibaraki 311-0102 (JP); YAMAGUCHI, Tomohiko, Naka-shi Ibaraki 311-0102 (JP)
(74) Representative: Gille Hrabal Partnerschaftsgesellschaft mbB Patentanwälte
(86) International application number: PCT/JP2018/008743
(87) International publication number: WO 2018/180306

(56) References cited:
- WO-A1-2014/021204
- WO-A1-2016/039057
- JP-A- S61 262 482
- JP-A- S61 262 482
- JP-A- S63 260 698
- JP-A- S63 260 698
- US-A1- 2003 224 197
- HU TIANQI ET AL: "Cu@Sn Core-Shell Structure Powder Preform for High-Temperature Applications Based on Transient Liquid Phase Bonding", IEEE TRANSACTIONS ON POWER ELECTRONICS, INSTITUTE OF ELECTRICAL AND ELECTRONICS ENGINEERS, USA, vol. 32, no. 1, 1 January 2017 (2017-01-01), pages 441-451, XP011623412, ISSN: 0885-8993, DOI: 10.1109/TPEL.2016.2535365 [retrieved on 2016-09-16]
- CHEN, H. T. et al.: "Cu@bn core-shell structure powder preform for high-temperature applications based on transient liquid phase bonding", IEEE Transactions on Power Electronics, vol. 32, no. 1, January 2017 (2017-01), pages 441-451, XP011623412,

## Description

### TECHNICAL FIELD

The present invention relates to a molded body for joining and a method for manufacturing the same, which are suitably used in allowing the molded body for joining to be interposed between electronic components such as semiconductor chip elements, LED chip elements, etc. which are members to be bonded and a substrate to mount such electronic components which are members to be bonded onto the substrate.

### BACKGROUND ART

In recent years, attention has been drawn to wide-gap semiconductors like SiC, which operate even at a high temperature above 200°C. As a method of joining semiconductor chip elements which operate at a high temperature, attention has been drawn to a joining method called the Transient Liquid Phase Sintering Method (TLP method) of allowing joining materials containing Cu and Sn to be interposed between semiconductor chip elements and the substrate to heat them at a temperature higher than the melting point of Sn to allow those joining materials to be Inter-Metallic Compound (IMC) having a composition of Cu₆Sn₅ or Cu₃Sn. A Cu-core Sn-shell structure powder preform for high-temperature applications based on such joining method is disclosed (see e.g., Nonpatent Literature 1).

For such Cu-core Sn-shell structure powder preform of the Nonpatent Literature 1, Cu particles having a particle size of 30 µm are dropped into an electroless Sn plating solution so that they are coated with Sn layer having a thickness of about 2 to 3 µm thereafter to press these particles such that there result preforms, i.e., molded bodies for the next applications. Respective Cu particles within the molded body are coated with Sn layers to form Cu-core Sn-shell powder structure. When the molded body is heated up to 232°C, Sn layers of the outer shell are molten and are then integrated with molten Sn of neighboring particles so that air gaps which were present at gaps between these particles are discharged toward the outside of the bonding layer and are thus densified. By this method, Cu particles will be uniformly distributed on the joining surface thereof. When the reflow time is prolonged, Cu₆Sn₅ compound and Cu₃Sn compound are formed by interdiffusion between the Cu core and the Sn shell. Finally, Sn of the outer shell will be completely consumed so that it results in inter-metallic compound (IMC). Because Cu particles are surrounded by Cu-Sn inter-metallic compound (Cu₆Sn₅ or Cu₃Sn), and melting points of Cu₆Sn₅ and Cu₃Sn are respectively 415°C and 676°C, it is possible to withstand higher temperatures at least up to 415°C.

JP S61 262482 A discloses a molded body for joining which is composed of solder powders. The body is impregnated with a flux such that the flux exists only in the open holes.

### PRIOR ART DOCUMENT

### PATENT DOCUMENT

Nonpatent Literature 1: Tianqi Hu et al., "Cu@SnCore-Shell Structure Powder Preform for High-Temperature Applications Based on Transient Liquid Phase Bonding", IEEE Transactions on Power Electronics, February 2016

### SUMMARY OF THE INVENTION

### PROBLEM TO BE SOLVED BY THE INVENTION

However, with the Cu-core Sn-shell structure powder preform described in the Nonpatent literature 1, when an native oxide films are formed on the surfaces of the Cu-core Sn-shell structure powder before molding or forming, even if this preform, i.e., molded body is disposed between the semiconductor chip element which is a member to be bonded and the substrate to implement reflow thereto, Sn of the outer shell was difficult to get wet with the Cu particle surfaces, and it was thus difficult to join the semiconductor chip element onto the substrate with a high strength.

An object of the present invention is to provide a molded body for joining and a method of manufacturing the same, which can solve the above-mentioned problems to realize joining having an initial joining strength and sufficient to maintain a higher joining strength also after the thermal cycle.

### MEANS FOR SOLVING PROBLEM

A first aspect of the present invention is directed to a molded body for joining composed of a compressed aggregate of Cu-core Sn-shell powders, characterized in that activating agent-containing substances for removing oxides on the powder surfaces exist in both closed holes and open holes within the molded body for joining; that the molded body for joining contains Cu in a ratio of 55 to 95% by mass and Sn in a ratio of 45 to 5% by mass respectively; that an activating agent in the activating agent-containing substance is contained in a ratio of 0.01 to 2% by mass to 100% by mass of the molded body for joining, and that the molded body for joining has a thickness of 20 to 400 µm. In this specification, "open hole" refers to a pore communicating with the exterior surface of the molded body for joining, which is called "open pore" among holes existing within the molded body for joining, and "closed hole" refers to a pore which does not communicate with the exterior surface of the molded body for joining, which is called "(closed pore)".

A second aspect of the present invention is a method of manufacturing a molded body for joining according to the first aspect of the invention, characterized by: including a step of uniformly mixing, into Cu-core Sn-shell powders having an average particle size of 0.5 to 50 µm, activating agent-containing substances for removing oxides on the surfaces of the powders under the atmosphere of an inert gas to prepare a mixture; and a step of implementing the press forming or the roll rolling forming to the mixture at a pressure of 10 to 1000 MPa under the atmosphere of an inert gas to obtain a pellet-shaped or sheet like molded body having a thickness of 20 to 400 µm, thus to carry out mixing so that the Cu-core Sn-shell powders contain Cu in a ratio of 55 to 95% by mass and Sn in a ratio of 45 to 5% by mass respectively, and includes the activating agent-containing substances in a ratio of 0.01 to 2% by mass in the mixture.

### EFFECT OF THE INVENTION

In the molded body for joining of the first aspect of the present invention, at both closed holes and open holes within the molded body for joining comprised of compressed aggregate of the Cu-core Sn-shell powders, there exist activating agent-containing substances for removing oxides on the powder surfaces. By such structural characteristic, at the time of preserving the molded body for joining, it is possible to prevent oxidation of outer shell Sn of the Cu-core Sn-shell powders. Moreover, even if native oxide film is formed on the surface of the outer shell Sn layer, when such molded body for joining is disposed on the joining surface between a joined member like the electronic components and the substrate to apply joining by heating (hereinafter referred to as heating joining) thereto, the activating agent in the activating agent-containing substance can remove the oxide of the outer shell Sn layer. Thus, Sn will be molten in a short time and is allowed to get wet with the Cu core particle surface so that liquid phase sintering is rapidly developed, and Sn will be joined to the outer shell Sn of the neighboring Cu-core Sn-shell powder so that there can result an integrated bonding layer. If the joining heating is continued, interdiffusion between Cu of the core and Sn of the shell takes place so that there is formed a densified bonding layer having high temperature resistance where the Cu core particles are surrounded by Cu₆Sn₅ compound and Cu₃Sn compound, thus making it possible to realize a joining having a high initial joining strength and sufficient to maintain a high joining strength also after the thermal cycle test. In addition, as the result of the fact that Cu remains within the molded body for joining, when a bonding layer is formed by using this molded body for joining, the bonding layer is permitted to have a higher thermal conductivity and a higher electric conductivity.

In the method of manufacturing molded body for joining according to the second aspect of the present invention, press forming or roll rolling forming is implemented so that there can be provided a molded body in which there exists lesser air gaps therewithin from the stage before joining heating. As a result, it becomes easier to densify the bonding layer at the time of joining heating. Moreover, because the activating agent-containing substances are uniformly mixed into the Cu-core Sn-shell powders prior to manufacturing the molded body unlike only the Cu-core Sn-shell powders are pressed to manufacture a molded body as in the Nonpatent Literature 1, although air gaps, i.e., both closed holes and open holes are formed between the Cu-core Sn-shell powders in the method of the Nonpatent literature 1, respective inner walls of the closed holes and open holes are coated with the activating agent-containing substances by this method so that activating agent-containing substances will exit in these pores. By implementing the press forming or the roll rolling forming to the mixture of the Cu-core Sn-shell powders and the activating agent-containing substances, it is possible to manufacture molded bodies for joining such that there are many contacts between powders and activating agent containing substances are uniformly dispersed between the Cu-core Sn-shell powders. Particularly, there is no contact with the atmosphere in the open holes to prevent oxidation when preserving the molded body for joining, and to permit the activating agent to remove oxides on the open hole surface at the time of joining heating so that the liquid phase sintering will be rapidly developed.

### BRIEF DESCRIPTION OF DRAWINGS

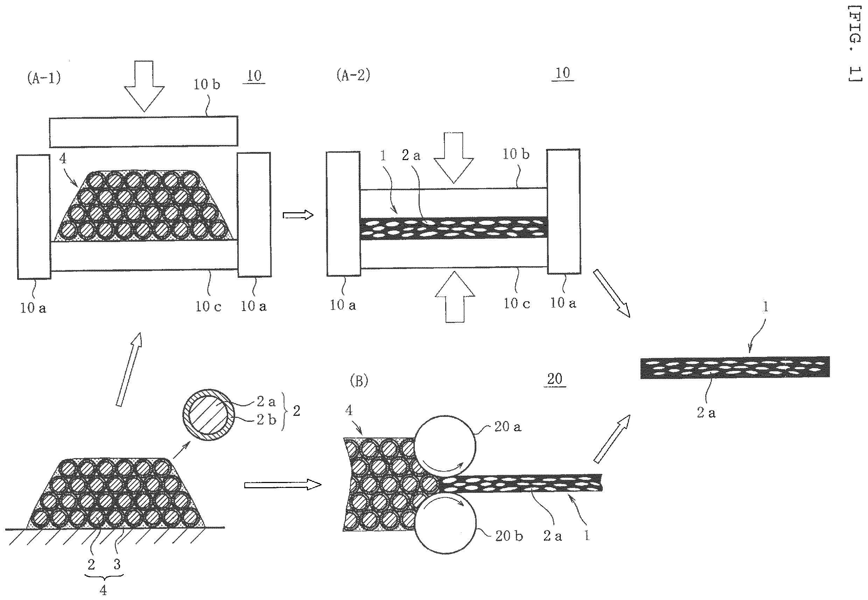

FIG. 1 is a diagram illustrating steps of manufacturing a molded body for joining according to an embodiment of the present invention. FIG. 1(A-1) and FIG. 1(A-2) are diagrams respectively schematically illustrating a uniaxial press machine before the press forming and a uniaxial press machine after the press forming. FIG. 1(B) is a diagram schematically illustrating a rolling mill during the roll rolling.

### BEST MODE(S) FOR CARRYING OUT THE INVENTION

The mode for carrying out the present invention will now be described with reference to the attached drawings.

As illustrated in FIG. 1, a molded body 1 for joining according to the present embodiment is manufactured in the form of a pellet having a thickness of 20 to 400 µm or in the form of a sheet of the same thickness by implementing press forming or roll rolling forming to mixtures 4 in which activating agent-containing substances 3 are uniformly mixed into Cu-core Sn-shell powders. FIG. 1(A-1) and FIG. 1(A-2) illustrate a uniaxial press machine 10, and FIG. 1(B) illustrates a rolling mill 20.

### Cu-core Sn-shell powder

The Cu-core Sn-shell powder 2 serving as a raw material of a molded body for joining is composed, as illustrated in the enlarged diagram of FIG. 1, a core 2a consisting of Cu, and a shell 2b consisting of Sn, which covers the core 2a. The average particle size of the Cu-core Sn-shell powders 2 is 0.5 to 50 µm, and preferably 1.0 to 20 µm. When the average particle size is less than 0.5 µm which is the lower limit thereof, it is known that not only it is difficult to manufacture a molded body having a uniform density in carrying out the press forming or roll rolling forming, but also diffusion of Cu will be developed in several hours on the interface between Cu and Sn of the double layered particles under a temperature to handle ordinary materials such as 25°C, etc. Therefore, substantially total amount of the outer shell Sn would result in Cu₆Sn₅ in the middle of temperature elevation before the Sn liquid phase is produced at the time of joining heating, leading to the fact that the joining performance will be inconveniently deteriorated. On the other hand, when the average particle size is above 50 µm of the upper limit thereof, Sn will be molten at the time of joining heating so that it becomes easier to be integrated therewith, but Cu and Sn are subjected to interdiffusion so that much time is required in order to form inter-metallic compound. As a result, there is an inconvenience such that short time joining which is one of effects of the present invention fails to be realized. Further, in the case of obtaining a thin molded body precursor which is thinner than the particle size of Cu disposed at the center of the powder of the double layered structure, it is necessary to deform not only the outer shell Sn but also Cu, but there is an inconvenience such that because Cu is harder than Sn and it is thus difficult to deform, when the average particle size is above 50 µm of the upper limit thereof, Cu will be exposed to the uppermost surface, and Cu is thus oxidized so that the wettability will be deteriorated, and because the existing ratio of Sn on the surface portion thereof is reduced, Sn of the liquid phase pertaining to the bonding is difficult to appear on the bonding surface, thus deteriorating the joining property. It is to be noted that average particle sizes (volumetric base) of powders are values measured by the laser diffraction scattering method (made by Horiba Seisakusho, LA960).

Moreover, the Cu-core Sn-shell powders 2 contain, when the Cu-core Sn-shell powder is assumed as 100% by mass, Cu in a ratio of 55 to 95% by mass and Sn in a ratio of 45 to 5% by mass respectively. Preferred contents are 60 to 85% by mass for Cn and 40 to 15% by mass for Sn respectively. When the content of Cu is above 95% by mass and the content of Sn is less than 5% by mass, there is an inconvenience that sinterability at the time of joining heating is low, and the bonding layer is not integrated so that the joining strength becomes lower and the thermal resistance becomes high. Further, when the content of Cu is less than 55% by mass and the content of Sn is above 45% by mass, there is an inconvenience that high temperature heat resistance of the final composition of the bonding layer is low so that any expected performance cannot be provided.

As a method of manufacturing the Cu-core Sn-shell powders 2, there are mentioned a method of manufacturing both the core and the shell by the wet method, and a method of manufacturing, by the wet method, only the shell by using Cu fine powder as the core. In the former manufacturing method, reducing agent is first added into an aqueous solution in which Cu ions and Sn ions coexist to allow Cu having a higher oxidation-reduction potential to be subjected to reductive deposition, and to subsequently allow Sn having a lower oxidation-reduction potential to be subjected to reductive deposition so as to cover this Cu to thereby manufacture powder precursor of the Cu-core Sn-shell structure. For the reducing agent, there may be employed such as a manipulation to stepwise add weak reducing agent which reduces only Cu and strong reducing agent which also reduces Sn so that reductive deposition reaction for Cu and reductive deposition reaction for Sn are separate. Further, in the latter manufacturing method, Cu fine powders may be prepared in advance to allow them to be highly dispersed in an aqueous solution containing Sn ions to add reducing agent thereinto to allow Sn to be subjected to reductive deposition onto the dispersed Cu fine powder surface. Further, for the purpose of preventing aggregation of powder precursors of the synthesized Cu-core Sn-shell structure, dispersant such as hydroxypropyl methylcellulose or polyvinyl pyrrolidone, etc. may be added into the aqueous solution at the time of preparing the aqueous solution. By washing the powder precursors of the synthesized Cu-core Sn-shell structure thereafter to collect and dry them, fine powders of the Cu-core Sn-shell structure are provided.

### [Activating agent-containing substance]

The activating agent-containing substance 3 which serves as another raw material of the molded body for joining is flux containing activating agent component, or is solvent containing activating agent component. As such activating agent, hydrogen halide acid amine salt is preferably adopted, and there are specifically mentioned hydrochloride or hydrobromide of amine such as triethanolamine, diphenyl guanidine, ethanolamine, butylamine, aminopropanol, polyoxyethylene oleylamine, polyoxyethylene laurelamine, polyoxyethylene stearylamine, diethylamine, triethylamine, methoxypropylamine, dimethylaminopropylamine, dibutylaminopropylamine, ethyl hexylamine, ethoxypropylamine, ethylhexyl oxypropylamine, bispropylamine, isopropylamine, diisopropylamine, piperidine, 2, 6 - dimethylpiperidine, aniline, methylamine, ethylamine, butylamine, 3 - amino - 1 - propene, isopropylamine, dimethyl hexylamine, cyclohexylamine, etc. Among these substances, cyclohexylamine hydrobromide may be preferably adopted.

As the solvent, there are mentioned organic solvents having a boiling point of 180°C or more such as diethylene glycol monohexyl ether, diethylene glycol monobutyl ether, diethylene glycol monobutyl ether acetate, tetraethylene glycol, 2 - ethyl - 1, 3 - hexanediol, and α - terpineol, etc. Among these substances, α - terpineol may be preferably adopted. For the activating agent-containing substance consisting of solvent containing activating agent component, there may be mentioned, e.g., a substance obtained by containing activating agent component into a solvent in which sebacic acid is dissolved into α - terpineol at a concentration of 5% by mass.

In the flux, in addition to the activating agent, the above-mentioned solvents, rosin and thixotropic agent may be included. For the activating agent-containing substance consisting of flux containing activating agent component, there may be mentioned, e.g., general purpose flux for lead free solder (92MS, made by Arakawa Kagaku). The content ratio of the activating agent included in the flux or the solvent is determined so that it becomes equal to 0.01 to 2% by mass, preferably 0.5 to 1% by mass to 100% by mass of the mixture which will be described later. The content ratio of the activating agent is the same as a content ratio in a molded body for joining when it finally results in the molded body for joining.

### [Method of manufacturing molded body for joining]

Referring to manufacturing of molded body for joining, Cu-core Sn-shell powders 2 and activating agent-containing substances 3 which contain an activating agent component are first mixed for a sufficient time period by using mortar, V blender, ball mill, or shaker mill, etc. under the atmosphere of an inert gas such as nitrogen, or argon to prepare the Cu-core Sn-shell powders which are powders of the double layer structure and the activating agent-containing substances into a mixture 4 having a substantially uniform composition. By this mixing, respective inner walls of air gaps, i.e., closed holes and open holes between the Cu-core Sn-shell powders are covered with the activating agent-containing substances so that those activating agent-containing substances will exist between powders.

As illustrated in FIG. 1(A-1) and(A-2), the mixtures 4 thus obtained are subjected to uniaxial press forming by means of uniaxial press machine 10, or as illustrated in FIG. 1(B), the mixtures thus obtained are subjected to roll rolling forming by means of rolling mill 20. Both the uniaxial press forming and the roll rolling forming are carried out in the atmosphere of inert gas such as nitrogen or argon, etc.

The uniaxial press forming will be first described. The uniaxial press machine 10 includes a die 10a serving as a mold, and an upper punch 10b and a lower punch 10c. In order to manufacture a molded body for joining by means of this uniaxial press machine 10, mixtures 4 are first weighed by a predetermined amount thereof in the state where the lower punch 10c is combined with the die 10a to insert it from an upper punch insertion hole of the die 10a onto the lower punch 10c (FIG. 1(A-1)). Although not illustrated, the mixture 4 is subjected to tapping from above by means of jig so that it is allowed to have a uniform thickness. Next, the upper punch 10b is inserted into the die 10a, and is then lowered (FIG. 1(A-2)). The Cu-core Sn-shell powders 2 in the mixture 4 are deformed by pressure applying force of the upper punch 10b. Thus, there take place intertwining and/or adhesion between powders so that there results an independent molded body. At this time, activating agent-containing substances 3 in the mixture 4 coat the respective inner walls of the closed holes and the open holes between powders and are present in the closed and open pores. Cu of the core in the molded body which is compressed aggregate is designated at reference numeral 2a (FIG. 1(A-2)). In this way, the mixture 4 is subjected to uniaxial pressing at the uniaxial press machine 10 to mold it so as to have a predetermined thickness of 20 to 400 µm. The molding or forming pressures vary in dependency upon particle size and/or composition of the Cu-core Sn-shell powders 2. For this reason, it is impossible to individually limit them in order that there result pressures corresponding to particle sizes, compositions and/or shapes of respective fine powders, but press forming is carried out within the range between 10 and 1000 MPa. At this time, the cross section of the molded material is observed to determine a powder amount to be added so that the area of air gaps consisting of components except for metallic components of Cu and Sn becomes equal to 5% to 0.1%, and to adjust pressure so as to have the above-described predetermined thickness. Although not illustrated, the inner wall of the air gap portion is coated with the activating agent-containing substance after the uniaxial press forming.

Then, the roll rolling forming will now be described. The rolling mill 20 includes a pair of columnar upper roll 20a and columnar lower roll 20b. The upper roll 20a and the lower roll 20b are configured to rotate in directions opposite to each other to perform rolling of the mixture 4 delivered from the left side toward the right direction in FIG. 1. After a gap between these rolls is adjusted, mixture 4 is inserted into by using dedicated feeder (not shown) to perform roll rolling. In the case of the roll rolling, there results a linear pressure, and it is difficult to perform confirmation and management of a pressure applied to the Cu-core Sn-shell powders 2 actually rolling-molded. For this reason, although it is impossible to limit pressure, a gap between rolls is adjusted such that there results a predetermined thickness of 20 to 400 µm similarly to the uniaxial press forming, and an amount of the mixture 4 to be inserted by the feeder is adjusted such that the airgap portion takes 5% to 0.1% upon observation of the cross section of the molded material. Although not illustrated, the inner walls of the air gap parts are covered with the activating agent-containing substances after roll rolling forming.

In the uniaxial press forming, after forming, the upper punch 10b is released from the mold to take out the molded body 1 for joining. In dependency upon the shape of the mold, a pellet-shaped or sheet like molded body for joining is obtained. In the roll rolling forming, a rolled molded body is cut so as to have a predetermined size. Thus, molded bodies 1 for joining are obtained. The sheet like or pellet-shaped molded bodies for joining are obtained in dependency upon the cutting method. The shape and the size of this molded body for joining are respectively determined in accordance with the shape and the size of the joining surface of electronic components which are members to be joined. A molded body for joining obtained by the uniaxial press forming or the roll rolling forming is composed of a compressed aggregate of the Cu-core Sn-shell powders, and activating agent-containing substances for removing oxides on the powder surfaces are present in both closed holes and open holes therewithin. Cu is contained in a ratio of 55 to 95% by mass and Sn is contained in a ratio of 45 to 5% by mass respectively in the molded body for joining.

### [Joining method using molded body for joining]

An example of joining a silicon chip element onto a substrate of a copper plate by using the molded body for joining manufactured by the above-mentioned method to mount the silicon chip element onto the substrate will now be descried. First, the molded body for joining is disposed on the copper plate to mount, on the molded body for joining, 2.5 mm square silicon chip element of which back surface has been subjected to Au sputtering. Next, heating holding treatment is performed for 1 to 15 min. under the condition of the maximum temperature 250 to 350°C while applying load of 0.1 to 100 MPa under a nitrogen gas atmosphere by using bonding furnace, e.g. SRS-1C made by MALCOM company. The activating agents in the molded body for joining remove oxides of the outer shell Sn layers of the powders by the joining heating, whereby Sn is molten in a short time so that inter-metallic compound (IMC) of Cu-Sn is formed so as to surround Cu of the core by the interdiffusion between Cu and Sn. Thus, the silicon chip element and the copper plate are joined at a high joining strength.

Regarding this joining heating condition, the heating temperature and the heating time are determined from the above-mentioned range by the average particle size of the Cu-core Sn-shell powders in the molded body for joining. According as the average particle size of the Cu-core Sn-shell powders becomes smaller, a lower heating temperature and a shorter heating time are determined within the range. On the contrary, according as the average particle size of the Cu-core Sn-shell powders becomes larger, a higher heating temperature and a longer heating time are determined within the range. When the heating temperature is less than 250°C or the heating time is less than one min., even if the average particle size is 0.5 µm, Sn is difficult to be molten so that no intermetallic compound of Cu-Sn is formed, and the joining strength is not allowed to be high. Further, when the heating temperature is above 350°C or the heating time is above 15 min., there is an inconvenience that thermal damage may be applied to silicon chip element which is a member to be joined.

### EXAMPLES

Examples according to the present invention will now be described in more detail in conjunction with comparative examples.

### <Example 1>

There were prepared Cu-core Sn-shell powders in which the average particle size is 0.5 µm, and the Cu ratio is 75% by mass and Sn ratio is 25% by mass. In this example, the composition ratio of Cu and Sn of the Cu-core Sn-shell powders was measured by the ICP emission spectroscopy (made by the Thermo Fisher Scientific company, iCAP-6500 Duo). Moreover, the fact that the crystal structure of the core-shell structure mainly consists of Cu and Sn was confirmed by the powder X-ray diffraction method (made by the PANalytical company, Multipurpose X-ray diffractometer Empyrean). Next, the Cu-core Sn-shell powders were contained into a mortar under nitrogen atmosphere to add general purpose flux (made by Arakawa Kagaku, 92MS) into the Cu-core Sn-shell powders to uniformly mix them for 30 min. Thus, a mixture is obtained. In this mixture, respective inner walls of gaps, i.e. closed holes and open holes between those Cu-core Sn-shell powders were coated with activating agent-containing substances. Regarding the mixing ratio of the Cu-core Sn-shell powders and general-purpose fluxes at this time, the Cu-core Sn-shell powders were 99% by mass, and the activating agent components in the general-purpose fluxes were 1% by mass. The mixture thus obtained was subjected to uniaxial press forming for 300 sec. at forming load 500 MPa by using the uniaxial press machine 10 illustrated in FIG. 1 to obtain a 3 mm square pellet-shaped molded body for joining having a thickness of 100 µm.

### <Examples 2 to 5 and Comparative examples 1, 2>

In the examples 2 to 5 and the comparative examples 1, 2, as shown in Table 1, with respect to average particle sizes of the Cu-core Sn-shell powders for manufacturing molded bodies for joining, molded bodies for joining were obtained in a manner similar to the example 1 by using the Cu-core Sn-shell powders having average particle sizes different from those of the example 1.

### <Examples 6 to 9 and Comparative examples 3, 4>

In the examples 6 to 9 and the comparative examples 3, 4, as shown in Table 1, with respect to compositions of Cu and Sn of the Cu-core Sn-shell powders for manufacturing molded bodies for joining, molded bodies for joining were obtained in a manner similar to the example 1 by using Cu-core Sn-shell powders having a composition different from that of the example 1.

### <Examples 10 to 12 and Comparative examples 5, 6>

In the examples 10 to 12 and the comparative examples 5, 6, as shown in Table 1, with respect to the mass ratio between components obtained by totalizing Cu and Sn (Cu·Sn components) of mixtures for manufacturing a molded body for joining and activating agent components in the activating agent-containing substances, molded bodies for joining were obtained in a manner similar to the example 1 by using mixtures having a mass ratio different from that of the example 1.

**Table 1**

| | Cu-core Sn-shell powder | | | Mixture | | Forming condition | | | Joining evaluation | |
|---|---|---|---|---|---|---|---|---|---|---|
| | Average particle size (µm) | Composition | | cu·Sn component (% by mass) | Activating agent component (% by mass) | Forming method (-) | Forming load (MPa) | Molded body thickness (µm) | Initial joining strength (MPa) | Thermal cycle (-) |
| | | Cu (% by mass) | Sn (% by mass) | | | | | | | |
| Example 1 | 0.5 | 75 | 25 | 99.0 | 1.0 | Uniaxial press | 500 | 100 | 38 | 0.78 |
| Example 2 | 1.0 | 75 | 25 | 99.0 | 1.0 | Uniaxial press | 500 | 100 | 50 | 0.89 |
| Example 3 | 5.0 | 75 | 25 | 99.0 | 1.0 | Uniaxial press | 500 | 100 | 55 | 0.98 |
| Example 4 | 20 | 75 | 25 | 99.0 | 1.0 | Uniaxial press | 500 | 100 | 48 | 0.86 |
| Example 5 | 50 | 75 | 25 | 99.0 | 1.0 | Uniaxial press | 500 | 100 | 40 | 0.84 |
| Comparative example 1 | 0.3 | 75 | 25 | 99.0 | 1.0 | Uniaxial press | 500 | 100 | 18 | 0.49 |
| Comparative example 2 | 60 | 75 | 25 | 99.0 | 1.0 | Uniaxial press | 500 | 100 | 22 | 0.39 |
| Example 6 | 5.0 | 55 | 45 | 99.0 | 1.0 | Uniaxial press | 500 | 100 | 58 | 0.62 |
| Example 7 | 5.0 | 60 | 40 | 99.0 | 1.0 | Uniaxial press | 500 | 100 | 55 | 0.71 |
| Example 8 | 5.0 | 85 | 15 | 99.0 | 1.0 | Uniaxial press | 500 | 100 | 48 | 0.89 |
| Example 9 | 5.0 | 95 | 5 | 99.0 | 1.0 | Uniaxial press | 500 | 100 | 44 | 0.90 |
| Comparative example 3 | 5.0 | 50 | 50 | 99.0 | 1.0 | Uniaxial press | 500 | 100 | 50 | 0.23 |
| Comparative example 4 | 5.0 | 97 | 3 | 99.0 | 1.0 | Uniaxial press | 500 | 100 | Joining impossible | |
| Example 10 | 5.0 | 75 | 25 | 99.99 | 0.01 | Uniaxial press | 500 | 100 | 40 | 0.80 |
| Example 11 | 5.0 | 75 | 25 | 99.5 | 0.5 | Uniaxial press | 500 | 100 | 48 | 0.83 |
| Example 12 | 5.0 | 75 | 25 | 98.0 | 2.0 | Uniaxial press | 500 | 100 | 39 | 0.79 |
| Comparative example 5 | 5.0 | 75 | 25 | 99.995 | 0.005 | Uniaxial press | 500 | 100 | 18 | 0.35 |
| Comparative example 6 | 5.0 | 75 | 25 | 97.5 | 2.5 | Uniaxial press | 500 | 100 | 15 | 0.42 |

### <Examples 13 to 16 and comparative examples 7, 8>

In the examples 13 to 16 and the comparative examples 7, 8, as shown in Table 2, with respect to the forming load at the time of performing uniaxial press forming when manufacturing a molded body for joining, molded bodies for joining were obtained in a manner similar to the example 1 at forming loads different from those of the example 1. A time during which load has been applied was 300 sec. which is the same as the example 1.

### <Examples 17 to 20 and comparative examples 9, 10>

In the examples 17 to 20 and the comparative examples 9, 10, as shown in Table 2, an amount of a mixture to be inserted into the mold was varied so that obtained molded bodies for joining have thicknesses different from those of the example 1. Thus, molded bodies for joining were obtained in a manner similar to the example 1 except therefor.

### <Examples 21 to 25 and comparative examples 11, 12>

In the examples 17 to 25 and the comparative examples 11, 12, as shown in Table 2, the forming method was changed into the roll rolling forming to adjust a gap between rolls of the rolling mill so that molded bodies for joining thus obtained have thicknesses different from those of the example 1. Thus, molded bodies for joining were obtained in a manner similar to the example 1 except therefor.

**Table 2**

| | Cu-core Sn-shell powder | | | Mixture | | Forming condition | | | Joining evaluation | |
|---|---|---|---|---|---|---|---|---|---|---|
| | Average particle size (µm) | Composition | | cu·Sn component (% by mass) | Activating agent component (% by mass) | Forming method (-) | Forming load (MPa) | Molded body thickness (µm) | Initial joining strength (MPa) | Thermal cycle (-) |
| | | Cu (% by mass) | Sn (% by mass) | | | | | | | |
| Example 13 | 5.0 | 75 | 25 | 99.0 | 1.0 | Uniaxial press | 10 | 100 | 38 | 0.78 |
| Example 14 | 5.0 | 75 | 25 | 99.0 | 1.0 | Uniaxial press | 50 | 100 | 44 | 0.80 |
| Example 15 | 5.0 | 75 | 25 | 99.0 | 1.0 | Uniaxial press | 100 | 100 | 52 | 0.93 |
| Example 16 | 5.0 | 75 | 25 | 99.0 | 1.0 | Uniaxial press | 1000 | 100 | 48 | 0.92 |
| Comparative Example 7 | 5.0 | 75 | 25 | 99.0 | 1.0 | Uniaxial press | 5 | 100 | 21 | 0.15 |
| Comparative example 8 | 5.0 | 75 | 25 | 99.0 | 1.0 | Uniaxial press | 2000 | 100 | 30 | 0.34 |
| Example 17 | 5.0 | 75 | 25 | 99.0 | 1.0 | Uniaxial press | 500 | 20 | 38 | 0.82 |
| Example 18 | 5.0 | 75 | 25 | 99.0 | 1.0 | Uniaxial press | 500 | 50 | 45 | 0.89 |
| Example 19 | 5.0 | 75 | 25 | 99.0 | 1.0 | Uniaxial press | 500 | 200 | 54 | 0.92 |
| Example 20 | 5.0 | 75 | 25 | 99.0 | 1.0 | Uniaxial press | 500 | 400 | 48 | 0.88 |
| Comparative Example 9 | 5.0 | 75 | 25 | 99.0 | 1.0 | Uniaxial press | 500 | 15 | 19 | 0.48 |
| Comparative example 10 | 5.0 | 75 | 25 | 99.0 | 1.0 | Uniaxial press | 500 | 450 | 40 | 0.32 |
| Example 21 | 5.0 | 75 | 25 | 99.0 | 1.0 | Roll rolling | - | 20 | 40 | 0.79 |
| Example 22 | 5.0 | 75 | 25 | 99.0 | 1.0 | Roll rolling | - | 50 | 48 | 0.88 |
| Example 23 | 5.0 | 75 | 25 | 99.0 | 1.0 | Roll rolling | - | 100 | 58 | 0.98 |
| Example 24 | 5.0 | 75 | 25 | 99.0 | 1.0 | Roll rolling | - | 200 | 50 | 0.85 |
| Example 25 | 5.0 | 75 | 25 | 99.0 | 1.0 | Roll rolling | - | 400 | 48 | 0.81 |
| Comparative example 11 | 5.0 | 75 | 25 | 99.0 | 1.0 | Roll rolling | - | 15 | 22 | 0.48 |
| Comparative Example 12 | 5.0 | 75 | 25 | 99.0 | 1.0 | Roll rolling | - | 450 | 40 | 0.35 |

### <Comparative evaluation>

37 kinds of molded bodies for joining which were obtained in the examples 1 to 25 and the comparative examples 1 to 12 were respectively mounted on copper plates, and 2.5 mm square silicon chip elements of which back side has been subjected to Au sputtering were mounted thereon. The silicon chip elements were maintained for 5 min. at a maximum temperature of 300°C under a nitrogen atmosphere by using the reflow furnace with a load of 1 MPa being applied thereto so that they are closely in contact with the copper plates to join the copper plates and the silicon chip elements to obtain 37 kinds of joined samples. The initial joining strength test and the thermal cycle test were carried out by the method described below in connection with these joined samples to perform evaluation thereof. The evaluation results thereof are shown in Table 1 and Table 2.

### (1) Initial joining strength

Regarding the joining strength, by means of the die share tester (made by A&D company, Tensilon Universal Testing Device RTF-1310), copper plates of 37 kinds of joined samples were respectively fixed to apply a force in a direction parallel to the copper plate from the silicon chip element side surface to measure a force when the silicon chip element is peeled or a force when it has been broken (Newton, N in unit) to allow a value obtained by dividing this value by joining area 2.5 mm x 2.5 mm = 6.25 mm² to be a joining strength (MPa in unit).

### (2) Thermal cycle

37 kinds of joined samples were respectively contained into the thermal cycle tester (made by ESPEC company, Thermal shock testing device TSA-73ES) to respectively set the lower limit temperature and the upper limit temperature to -40° and 200°C to repeat temperature lowering and temperature rising 1000 times to measure joining strengths in accordance with a method similar to the initial joining strength of the above-mentioned item (1) to allow a value obtained through division by the initial joining strength to be a thermal cycle characteristic. This means that when this is 1.00, the initial strength is maintained, and means that when this is 0.50, there results a lowering to one half of the initial joining strength.

When comparison between the examples 1 to 25 and the comparative examples 1 to 12 is made, the following facts were found out from the Tables 1 and 2.

Because there were used Cu-core Sn-shell powders, which are too fine, having an average particle size of 0.3 µm in the comparative example 1, unevenness in thickness of molded bodies which have been subjected to press forming is large, so the molded bodies cannot sufficiently contact at respective surfaces of the copper plate and the silicon chip element (hereinafter referred to as substrate and element) so that sufficient joining was not realized.

Because there were used Cu-core Sn-shell powders which are too coarse, having an average particle size of 60 µm in the comparative example 2, Sn of the liquid phase appears so that the initial joining between the substrate and the element was correspondingly obtained. However, because it takes much time that Cu diffuses into Sn, no inter-metallic compound is sufficiently produced through a thermal treatment of 5 min, so a reaction involving change in volume will be developed also during the thermal cycle test so that the joining strength could not be maintained.

Because the content of Cu in Cu-core Sn-shell powder is too small such that it takes 50% by mass, and the content of Sn is too large such that it takes 50% by mass in the comparative example 3, the Cu core will disappear, so it was impossible to relax stress produced in the thermal cycle test so that it was impossible to sufficiently maintain the joining strength.

Because the content of Cu in Cu-core Sn-shell powder is too large such that it takes 97% by mass, and the content of Sn is too small such that it takes 3% by mass in the comparative example 4, an amount of Sn liquid phase produced is insufficient, so it cannot wet-spread on the interface with the substrate or the element so that it was impossible to join them. For this reason, it was impossible to carry out the initial joining strength test and the thermal cycle test.

Because the content of metallic components of Cu and Sn in the mixture is too large such that it takes 99.995% by mass, and the content of the activating agent-containing substance is too small such that it takes 0.005% by mass in the comparative example 5, not only it was impossible to sufficiently eliminate oxides on the powder surfaces, but also elimination of oxides on respective surfaces of the substrate or the element becomes also insufficient, so Sn of the liquid phase cannot wet-spread, so the initial joining strength is also lower, and it was impossible for the joining strength after the thermal cycle test to maintain an initial value thereof.

Because the content of metallic components of Cu and Sn in the mixture is too small such that it takes 97.5% by mass, and the content of the activating agent-containing substance is too large such that it takes 2.5% by mass in the comparative example 6, contact between molten Sn is prevented, so there hardly results an integrated bonding layer so that a desired initial joining strength could not be obtained.

Because the forming load at the time of the uniaxial press forming was too lower such that it takes 5 MPa in the comparative example 7, it was impossible that there results in advance a densified molded body. For this reason, contact between molten Sn is difficult, so integrated bonding layer cannot be obtained so that the initial joining strength was a lower value.

Because the forming load at the time of the uniaxial press forming was too high such that it takes 2000 MPa in the comparative example 8, the molded body becomes hard so that the molded body is not easily deformed, and even if pressure and heat are applied to the molded body while being inserted between the substrate and the element, it was impossible to sufficiently ensure the contact surface without being capable of performing deformation following warp of the substrate or the element. From this fact, the molten Sn could not sufficiently wet-spread so that the initial joining strength did not reach a sufficiently high value.

Because the thickness of the molded body after the uniaxial press forming is too thin such that it takes 15 µm in the comparative example 9, an amount of Sn liquid phase produced from the bonding layer is insufficient so that it could not sufficiently wet-spread on the substrate or the element. Thus, a value of the initial joining strength could not become equal to a sufficient value.

Because the thickness of the molded body after the uniaxial press forming was too thick such that it takes 450 µm in the comparative example 10, the Sn liquid phase is sufficiently produced so that it was possible to obtain an initial joining strength, but because the thermal resistance is not small, heat is not easily dissipated from the molded body so that it was impossible to maintain the initial joining strength through the thermal cycle test.

Because the thickness of the molded body after the roll rolling forming was too thin such that it takes 15 µm in the comparative example 11, an amount of Sn liquid phase produced from the bonding layer is insufficient, and it cannot wet-spread on the substrate or the element so that the value of the initial joining strength was not sufficient.

Because the thickness of the molded body after the roll rolling forming was too thick such that it takes 450 µm in the comparative example 12, Sn liquid phase is sufficiently produced. For this reason, the initial joining strength could be obtained. However, since the thermal resistance is not small, heat is not easily dissipated from the molded body so that it was impossible to maintain the initial joining strength through the thermal cycle test.

On the contrary, since the joined samples of the examples 1 to 25 were samples obtained by molded bodies for joining, which have the requirement specified at the first point of view, and have been manufactured in accordance with the requirement specified at the second point of view, the initial joining strength was high such that it takes 38 to 58 MPa, the thermal cycle was within the range of 0.62 to 0.98, and lowering of the joining strength by the thermal cycle test was not observed.

### Industrial Applicability

The present invention can be suitably utilized for mounting of electronic components which may be exposed to high temperature atmosphere.

## Claims

1. A molded body for joining composed of a compressed aggregate of Cu-core Sn-shell powders,
**characterized in**
**that** activating agent-containing substances for removing oxides on the surfaces of the powders exist in both closed holes and open holes within the molded body for joining;
**that** the molded body for joining contains Cu in a ratio of 55 to 95% by mass and Su in a ratio of 45 to 5% by mass respectively;
**that** an activating agent in the activating agent-containing substance is contained in a ratio of 0.01 to 2% by mass to 100% by mass of the molded body for joining; and
**that** the molded body for joining has a thickness of 20 to 400 µm.

2. A method of manufacturing a molded body for joining according to claim 1, **characterized by** including:
a step of uniformly mixing, under the atmosphere of an inert gas, into Cu-core Sn-shell powders having an average particle size of 0.5 to 50 µm, activating agent-containing substances for removing oxides on the surfaces of the powders thus to prepare a mixture; and
a step of implementing the press forming or the roll rolling forming to the mixture at a pressure of 10 to 1000 MPa under the atmosphere of an inert gas to obtain a molded body in the form of pellet or in the form of sheet having a thickness of 20 to 400 µm,
to carry out mixing so that the Cu-core Sn-shell powders contain Cu in a ratio of 55 to 95% by mass and Sn in a ratio of 45 to 5% by mass respectively, and include the activating agent-containing substances in a ratio of 0.01 to 2% by mass in the mixture.

## Patentansprüche

1. Ein Formkörper zum Verbinden, zusammengesetzt aus einem komprimierten Gemenge von Cu-Kern-Sn-Mantel-Pulvern,
dadurch charakterisiert,
dass aktivierende Mittel enthaltende Substanzen zur Entfernung von Oxiden auf den Oberflächen der Pulver sowohl in geschlossenen Löchern als auch offenen Löchern in dem Formkörper zum Verbinden vorliegen;
dass der Formkörper zum Verbinden Cu in einem Anteil von 55 bis 95 Gewichts-% beziehungsweise Sn in einem Anteil von 45 bis 5 Gewichts-% enthält;
dass ein aktivierendes Mittel in der aktivierendes Mittel enthaltenden Substanz in einem Anteil von 0,01 bis 2 Gewichts-% bezogen auf 100 Gewichts-% des Formkörpers zum Verbinden enthalten ist; und
dass der Formkörper zum Verbinden eine Dicke von 20 bis 400 µm aufweist.

2. Ein Verfahren zur Herstellung eines Formkörpers gemäß Anspruch 1, dadurch charakterisiert, dass es einschließt:
einen Schritt des einheitlichen Mischens unter einer Inertgasatmosphäre von aktivierende Mittel enthaltenden Substanzen zur Entfernung von Oxiden auf den Oberflächen der Pulver in die Cu-Kern-Sn-Mantel-Pulver, die eine mittlere Teilchengröße von 0,5 bis 50 µm aufweisen, um auf diese Weise eine Mischung herzustellen; und
einen Schritt der Implementierung der Pressformung oder der Rollformung der Mischung bei einem Druck von 10 bis 1000 MPa unter der Atmosphäre eines Inertgases, um einen Formkörper in Pelletform oder in der Form eines Bogens mit einer Dicke von 20 bis 400 µm zu erhalten,
das Mischen in einer solchen Weise auszuführen, dass die Cu-Kern-Sn-Mantel-Pulver Cu in einem Anteil von 55 bis 95 Gewichts-% beziehungsweise Sn in einem Anteil von 45 bis 5 Gewichts-% enthalten, und die aktivierende Mittel enthaltenden Substanzen in einem Anteil von 0,01 bis 2 Gewichts-% in dem Gemisch eingeschlossen sind.

## Revendications

1. Corps moulé destiné à la jonction et composé d'un agrégat comprimé de poudres à noyau de Cu et à enveloppe de Sn,
**caractérisé en ce**
**que** l'activation des substances contenant des agents pour enlever des oxydes sur les surfaces des poudres se fait dans les trous fermés et les trous ouverts à l'intérieur du corps moulé destiné à la jonction ;
**que** le corps moulé destiné à la jonction contient respectivement du Cu dans une proportion de 55 à 95% en masse et du Su dans une proportion de 45 à 5% en masse ;
**qu'**un agent d'activation dans la substance contenant l'agent d'activation est contenu dans une proportion de 0,01 à 2 % en masse par rapport à 100 % en masse du corps moulé destiné à la jonction ;
et
**que** le corps moulé destiné à la jonction comprend une épaisseur de 20 à 400 µm.

2. Procédé de fabrication d'un corps moulé destiné à la jonction selon la revendication 1, **caractérisé en ce qu'**il comprend :
une étape de mélanger de manière uniforme, sous l'atmosphère d'un gaz inerte, des substances contenant un agent d'activation dans des poudres à noyau de Cu et à enveloppe de Sn ayant une taille de particules moyenne comprise entre 0,5 et 50 µm, pour enlever des oxydes sur les surfaces des poudres, et ainsi préparer un mélange ; et
une étape de mettre en oeuvre le formage à la presse ou la formation par roulage à rouleaux du mélange sous une pression comprise entre 10 et 1000 MPa sous l'atmosphère d'un gaz inerte pour obtenir un corps moulé en forme d'un pellet ou en forme d'une feuille ayant une épaisseur comprise entre 20 et 400 µm,
une étape d'effectuer le mélange, de sorte que les poudres à noyau de Cu et à enveloppe de Sn contiennent respectivement du Cu dans une proportion de 55 à 95 % en masse et du Sn dans une proportion de 45 à 5 % en masse, et qu'elles comprennent les substances contenant un agent d'activation dans une proportion de 0,01 à 2 % en masse dans le mélange.
